# EUROPEAN PATENT APPLICATION

(11) **EP 1 205 574 A2**
(43) Date of publication of application: **15.05.2002**
(21) Application number: 01309503.9
(22) Date of filing: 09.11.2001
(51) Int. Cl.: C23C 16/40, H01L 21/316

(54) **Atomic layer deposition of Ta205 and high-K dielectrics**

(30) Priority: 13.11.2000 US 712633
(71) Applicant: Applied Materials, Inc., Santa Clara, California 95054 (US)
(72) Inventor: Ravi, Jallepally, Santa Clara, CA 95051 (US); Duboust, Alain, Sunnyvale, CA 94086 (US); Li, Shih-Hung, Sunnyvale, CA 94086 (US); Song, Kevin, San Jose, CA 95148 (US); Majewski, Robert B., Watsonville, CA 95076 (US); Chen, Liang-Yuh, Foster City, CA 94404 (US); Carl, Daniel A., Pleasanton, CA 94566 (US)
(74) Representative: Setna, Rohan P.

(57) **Abstract**

Methods of forming compound thin films through atomic layer deposition using high-k dielectric Group VB species are described. A substrate is placed in a reaction chamber. A first reactant gas of a Group VB element is injected into the reaction chamber where it is chemisorbed as an atomic layer on the substrate surface. A second reactant gas, when injected into the reaction chamber, flows over the atomic layer of the first reactant gas and forms an atomic layer on the atomic layer of the first reactant gas. This process can be repeated, alternately subjecting the surface to the first reactant gas and the second reactant gas, until the compound thin film reaches the desired thickness. A purge gas is injected into the reaction chamber between two successive reactant gas injections to purge the chamber of any excess, or unreacted, reactant gas.

## Description

The present invention concerns the field of thin film technology for coating substrates in the manufacture of semiconductor devices and has particular application to atomic layer deposition.

In the field of thin film technology, requirements for thinner deposition layers, better uniformity over increasingly larger area substrates, larger production yields and higher productivity have been, and still are, the driving forces behind emerging technologies developed for coating substrates in the manufacture of various semiconductor devices. Various technologies known in the art exist for applying thin films to substrates, including sputtering, chemical vapor deposition (CVD) and atomic layer deposition (ALD) methods.

According to the sputtering method, argon (Ar) as an inert gas, is injected into a vacuum chamber in which high voltage is applied to a target to generate Ar ions in a plasma state. Then, Ar ions are attracted onto the surface of the target such that atoms of the target become dislodged and are deposited onto the surface of the substrate. Although high purity thin films with good adhesion to the substrates can be formed by the sputtering method, it is difficult to ensure uniformity over the entire thin film.

In the CVD method, a desired layer is deposited on a substrate to a desired thickness using decomposition and reaction of gases. First, various gases are injected into a reaction chamber, and chemical reactions between the gases are induced with high energy such as heat, light or plasma to deposit a thin film having a predetermined thickness on the substrate. The deposition rate of CVD can be increased by controlling either the amount and ratio of the gases or the reaction condition of heat, light or plasma supplied as the reaction energy. The reactions are so rapid, however, that it is difficult to control the thermodynamic stability of atoms. Another problem is that the CVD method tends to deteriorate the physical, chemical and electrical properties of the thin films. Furthermore, the close proximity of the reactants and the products of reaction to the deposition surface creates a high probability of the inclusion of reaction products and other contaminants in each deposited layer.

Forming and growing thin films by ALD is based on the principle of the formation of a saturated monolayer of reactive precursor molecules by chemisorption at the deposition surface of the substrate. In ALD, appropriate reactive gaseous precursors are alternately pulsed or injected into a reaction chamber. Each pulse or injection of a reactive precursor is separated by an inert gas purge. Each precursor pulse or injection provides a new atomic layer additive to previously deposited layers to form a uniform solid layer of film. The cycle is repeated to form the desired film thickness.

Specifically, the basic deposition sequence of ALD includes the following four steps: (1) a first reaction step wherein a first reactant in the vapor phase is saturatively chemisorbed at the surface of the substrate; (2) a second step of purging the excess, or unreacted, first reactant; (3) a third step of introducing a second reactant in the vapor phase on the substrate such that the desired reaction takes place; and (4) a fourth step of purging the reaction by-products and the excess, or unreacted, second reactant. Assuming two reaction gases A and B are used, for example, when only reaction gas A is injected into the reaction chamber, atoms of reaction gas A are chemisorbed on the substrate. Any reaction gas A that is not chemisorbed is then purged and replaced with an inert gas such as Ar or nitrogen (N₂). Next, reaction gas B is injected into the reaction chamber, and a chemical reaction between reaction gases A and B occurs only on the surface of the substrate on which reaction gas A has been chemisorbed, resulting in an atomic layer B on the substrate. Any unreacted reaction gas B, along with the by-products of the reaction between gases A and B, is then purged and replaced with the inert gas. These steps are repeated until the desired thickness of the thin film is obtained. In other words, the thickness of the thin film can be adjusted in atomic layer units according to the number of repetitions of steps (1)-(4).

One critical area of thin film technology is the ability of a system to provide a high degree of uniformity and thickness control over the complex topology inherent in many devices. This phenomena is typically referred to as "step coverage." As used herein, the term "step coverage" refers to the ability of the coating technique (i.e., CVD or ALD) to produce a film that covers all portions of a given topological feature and to replicate the shape of the surface on which it is being deposited. In the case of CVD, step coverage is better than other deposition processes such as, for example, plasma vapor deposition. CVD, however, includes the unavoidable feature of formation of nuclei at the beginning of the film growth. As a result, the film does not achieve a continuous structure until the single microcrystals (growing nuclei) touch each other, which generally does not occur until the mean thickness of the film is of the order of about 100 Angstroms. The resulting films have a polycrystalline structure, which adversely affects the electrical characteristics and the chemical stability of the films. In addition, other factors such as mean free path of molecules, critical topological dimensions and precursor reactivity further complicate processing, making it inherently difficult to obtain a high degree of uniformity with adequate step coverage over complex topology for ultra-thin films deposited via CVD.

An essential difference between ALD and other deposition methods resides in the fact that film growth proceeds stepwise, atomic plane by atomic plane, resulting from a surface reaction between one component element in the gas phase with the other as surface atoms in the growing compound film. As a result, the ALD method achieves near-perfect step coverage and allows for precise control over the thickness and composition of the grown thin film. ALD, although a slower process than CVD, demonstrates a remarkable ability to maintain ultra-uniform thin deposition layers over complex topology.

The unique mechanism of film formation provided by ALD offers several advantages over CVD and other thin film technologies. One advantage is the transparency of ALD to substrate size. For example, a 200 mm substrate will receive a uniform layer equal in thickness to one deposited on a 100 mm substrate processed in the same reactor chamber because of the self-limiting chemisorption phenomena described above. Another distinct advantage of the ALD process is the avoidance of high reactivity of precursors toward one another because chemical species are injected independently into an ALD reactor, rather than together. High reactivity, while troublesome in CVD, is exploited to an advantage in ALD because the reaction occurs directly on the wafer surface. This high reactivity enables lower reaction temperatures and simplifies process chemistry development. Yet another distinct advantage of ALD is that surface reaction by chemisorption contributes to near-perfect step coverage over complex topology.

A thin film having a high aspect ratio, good uniformity and good electrical and physical properties can be formed by ALD. Moreover, the films deposited by ALD have a lower impurity density than those formed by other deposition methods, and a film thickness of less than about 200 Angstroms with sufficient thickness uniformity can be obtained with reproducibility. ALD, therefore, is a superior method for achieving uniformity, excellent step coverage and transparency to substrate size.

While the ALD method can provide a thin film with a high aspect ratio, good uniformity and good electrical and physical properties, it is problematic in that it has been difficult to create an acceptable commercial process (i.e., one with adequate system throughput) because of the separate deposition of each film layer and the low deposition rate of the process (e.g., typically about 100 Angstroms per minute as compared to about 1,000 Angstroms per minute for CVD). The deposition rate may be increased by increasing the activation energy of the gases; however, increasing the activation energy of the gases results in CVD on the substrate instead of forming an atomic layer, thereby negating the advantages of the ALD method.

Dielectric materials, which may be deposited by ALD in the manufacture of semiconductor devices, are a key aspect to the performance of such devices. As semiconductor devices become smaller and the density of the circuitry thereon increases, the width, i.e., the spacing between, of the dielectric layers in the semiconductor devices decreases. Likewise, the need for thinner layers for the creation of very thin features such as capacitor electrodes increases. At the same time, the need for dielectric materials with a dielectric constant greater than that of the most common dielectric material, silicon dioxide (SiO₂), increases. These types of dielectric materials are sometimes referred to as "high-k dielectrics." As used herein, the terms "high-k dielectrics" and "high-k dielectric materials" refer to dielectric materials having a high dielectric constant relative to silicon dioxide. Typically, silicon dioxide has a dielectric constant of about 4, while high-k dielectric materials have a dielectric constant of greater than about 10. Not all dielectric materials, however, form acceptable thin dielectric layers for use in semiconductors.

In spite of the popularity of SiO₂ as a dielectric material, efforts continue in a search for new and highly-effective dielectric materials. While a variety of high-k dielectrics are known, tantalum oxide presents a particularly preferred dielectric. Tantalum oxide, as a class, however, presents special problems. The formula Ta₂O₅ represents the most common stoichiometric oxide of tantalum, but this material, when deposited by most thin film deposition techniques, is often not stoichiometric (i.e., the ratio of oxygen to tantalum is other than 2.5:1).

Another common problem associated with tantalum oxide is that it develops a crystalline structure under normal semiconductor processing conditions instead of forming a preferred amorphous structure. While SiO₂ easily withstands the high temperature processing conditions and remains amorphous at temperatures as high as 1100°C, high-k dielectrics like tantalum oxide crystallize at much lower temperatures. As a result, the surface of the film is very rough. Consequently, in the crystalline form, most high-k dielectrics and, particularly, tantalum oxide, are not suitable for fabrication of high performance semiconductor devices; therefore, it would be advantageous if high-k dielectric films could be formed with reduced surface roughness and crystallinity.

One object of the present invention is to provide a method of producing compound thin films.

Another object of the invention is to provide for the production of compound thin films by forming sequential, single atomic layers of the elements of which the compound thin films are formed.

Yet another object of the present invention is to deposit high-k dielectric materials on a substrate by atomic layer deposition while avoiding the problems associated with prior art methods.

The above and other objects, features and advantages of the present invention will become more apparent from the following detailed description of the presently preferred embodiments of the invention and to the appended claims.

FIG. 1 is an auger electron spectroscopy ("AES") depth profile for a Ta₂O₅ film made according to the present invention.

FIG. 2 is a graph depicting the deposition rate of Ta₂O₅ according to the present invention.

FIG. 3 is a graph depicting the ALD temperature window for Ta₂O₅ film using Ta(OC₂H₅)₅ and O₂ radicals as reactants according to the present invention.

FIG. 4 illustrates uniformity maps for Ta₂O₅ films made using ALD according to the present invention and CVD.

To promote an understanding of the principles of the present invention, descriptions of specific embodiments of the invention follow, and specific language is used to describe the same. It will nevertheless be understood that no limitation of the scope of the invention is intended by the use of this specific language and that alterations, modifications, equivalents and further applications of the principles of the present invention are contemplated as would normally occur to one of ordinary skill in the art to which the invention pertains.

As used herein, the term "substrate surface" refers to the surface of the substrate that is exposed to the vapor-phase reactant flowing into the reaction chamber. In practice, the substrate surface during the first cycle of the thin-film growing process (i.e., when the first reactant is chemisorbed) is the initial surface of the substrate as placed in the process chamber, which may include one or more film layers previously deposited thereon. In subsequent cycles, the substrate surface is the layer comprising the solid-state reaction product chemisorbed to the substrate.

To achieve the foregoing and other objects, and in accordance with the purpose of the present invention as embodied and broadly described herein, the present invention relates to methods of forming and growing tantalum oxide thin films by atomic layer deposition wherein a substrate surface is subjected to alternately repeated surface reactions of at least two different reactants. The reactants are admitted repetitively and alternately into the reaction chamber, each reactant from its own source, in the form of vapor-phase injections or pulses. The vapor-phase reactants are allowed to react with the substrate surface to form a compound, solid-state thin film on the substrate. A purge gas is used to sweep away the excess, or unreacted, starting material (i.e., the vapor-phase reactants) and the gaseous reaction products from above the substrate.

A conventional ALD apparatus typically includes a vacuum, or reaction, chamber, a reactor installed in the vacuum chamber for receiving a substrate, such as a semiconductor substrate, and a gas supply portion for supplying the gases to the chamber. The gas supply portion is attached to the reactor and supplies reaction gases and at least one purging gas using a pumping means. A pump for discharging any remaining gas from the reaction chamber is typically connected to the reaction chamber.

In one embodiment of the present invention, the gas supply portion supplies a first reaction gas such as, for example, the vapor of an element from Group VB of the periodic table, to the substrate in the reaction chamber for a predetermined duration. The first reaction gas is chemisorbed as an atomic layer on the substrate. After the single atomic layer of the first reaction gas is chemisorbed, the gas supply portion supplies a predetermined amount of purging gas such as, for example, Ar, N₂ or helium (He), to the reaction chamber to purge from the reaction chamber any unreacted first reaction gas that remains after the formation of the single atomic layer. The gas supply portion then supplies a second reaction gas such as, for example, oxygen ions or radicals, to the reaction chamber. The second reaction gas flows over the atomic layer of the first reaction gas that has chemisorbed to the substrate surface. The second reaction gas reacts with the first reaction gas chemisorbed to the substrate surface, thereby resulting in a single atomic layer of the reaction of the first and second reaction gases. A purging gas is then supplied to the reaction chamber to purge any unreacted second reaction gas and the by-products of the first and second reaction gases from the reaction chamber. Additional reaction gases (i.e., third and fourth reaction gases) may be supplied to the substrate according to the composition of the desired compound thin film.

Applicants' invention resides in part on the discovery that stoichiometric thin films of reduced surface roughness can be prepared using the ALD process by careful selection of the at least first and second reaction gases.

The ALD process is typically carried out in a reaction chamber at a pressure of about 0.1 Torr to about 500 Torr and at a temperature in the range of about 100°C to about 500°C. One primary feature of the process of the present invention is the formation of the compound thin film by a multiplicity of process cycles in which each cycle produces essentially an equivalent atomic layer of the film. A cycle is considered to be all the steps required to produce an equivalent atomic layer.

Any known substrate typically used in the production of semiconductors can be used in the method of the present invention. Suitable examples include glass, silicon, TiN, tungsten and gallium arsenide. The most common substrate is a silicon substrate. The substrate may be a bare wafer or may have an arbitrary film thereon, for example, an oxide film. Also, the substrate may have devices such as transistors thereon.

Tantalum is the preferred Group VB metal. Tantalum forms a variety of oxides and compounds such as, for example, Ta₂O₅, TaₓO_{y}N_{z} and TaAlO₄.

Compound thin films formed by the ALD method of the present invention are only limited by the number and kinds of reaction gases introduced to the substrate. In order for a reaction to occur, the reaction gases must be highly reactive with each other. The use of oxygen ions or radicals, which are a highly reactive species, as one of the reaction gases improves the likelihood of a reaction occurring between the reaction gases. As a result, numerous compound thin films can be formed by the method of the present invention.
Most preferably, the compound thin films formed by the method of the present invention are Group VB metal oxides.

For example, a Ta₂O₅ compound thin film can be made according to the ALD method of the present invention using Ta(OC₂H₅)₅ as the first reactant gas and oxygen ions or radicals as the second reaction gas.

The oxygen ions or radicals used in the present invention are generated using plasma as described in commonly owned U.S. Patent Application Serial No. 09/439,476, the relevant portions of which are incorporated herein by reference. In a preferred embodiment of plasma generation, there is a first reaction chamber with a gas source coupled to the first reaction chamber to supply a gas to the first reaction chamber, including constituents adapted to react with a substrate. An excitation energy source is coupled to the first reaction chamber to generate a plasma that includes ions and radicals from the gas such as, for example, oxygen ions and radicals. The excitation energy source may be a radio frequency ("RF") field. In the alternative, the excitation energy source may be a microwave cavity and a microwave generator that provides a microwave field to the microwave cavity. A second reaction chamber (i.e., vacuum chamber) is provided to house the substrate therein. The first reaction chamber is coupled to the second reaction chamber by an inlet member, and radicals of the plasma (i.e., oxygen radicals) flow through the inlet member into the second reaction chamber. The inlet member preferably includes a passageway having a cross-sectional dimension selected such that during processing, the pressure in the second reaction chamber is less than the pressure in the first reaction chamber.

Other suitable gases useful as the first reactant gas in the formation of a Ta₂O₅ compound thin film include, for example, [(CH₃CH₂)₂N]₃Ta, TaCl₅ and TaF₅. In addition to oxygen ions or radicals, other suitable second reactant gases include, but are not limited to, ozone (O₃) and water vapor.

A wide variety of compound thin films can be produced according to the teachings of the present invention. For example, in another embodiment of the present invention, a TaₓO_{y}N_{z} compound thin film can be made using the ALD procedure described above but with [(CH₃CH₂)₂N]₃Ta as the first reactant and oxygen ions or radicals as the second reactant. In addition to oxygen ions or radicals, other suitable gases for use as the second reactant gas include, but are not limited to, ozone (O₃) and water vapor. Nitrogen is also supplied by [(CH₃CH₂)₂N]₃Ta.

In yet another embodiment, a TaAlO₄ compound thin film can be made using the ALD process described above using Ta(OC₂H₅)₅ as the first reactant gas, oxygen ions or radicals as the second and fourth reactant gases and trimethyl aluminum, dimethyl aluminum, isopropoxy aluminum or other aluminum alkoxides as the third reactant gas. Other suitable gases useful as the first reactant gas in the formation of a TaAlO₄ thin film include, for example, [(CH₃CH₂)₂N]₃Ta, TaCl₅ and TaF₅. In addition to oxygen ions or radicals, other suitable gases for use as the second and fourth reactants include, but are not limited to, O₃ and water vapor.

In another embodiment, a mixture of Ta and Al is used as the first reactant, with the second reactant being oxygen ions or radicals, O₃ or water vapor.

A process of forming a film according to the present invention will now be described by reference to the following detailed example. The example is set forth by way of illustration and is not intended to be limiting in scope.

### EXAMPLE

### General Process

A silicon substrate is loaded into the reaction chamber, and the first reactant gas is introduced. In the specific example described here, the process is employed to form a thin Ta₂O₅ film. The reactant gases are, respectively, Ta(OC₂H₅)₅ and plasma generated (generated using an RF generator) oxygen radicals. The reactant gases are introduced alternately so that in each process cycle equivalent atomic layers of the reactant gases are deposited one atomic layer at a time on the substrate surface. The tantalum source, Ta(OC₂H₅)₅, is introduced first, and an atomic layer of tantalum is deposited on the substrate surface. The tantalum source is then turned off, and the system is purged using N₂ as the purge gas to flush all unreacted Ta(OC₂H₅)₅ from the reaction chamber. Thereafter, the second reactant gas, in this case oxygen radicals, is introduced and an atomic layer of oxide is deposited on the atomic layer of tantalum to form a thin Ta₂O₅ film. The oxygen source is then turned off, and the system is again purged with N₂ to flush unreacted oxygen radicals and the by-products of Ta(OC₂H₅)₅ and oxygen radicals. The Ta(OC₂H₅)₅ and the oxygen radicals are alternately introduced, with purging occurring between each introduction, until the desired thickness of the Ta₂O₅ film is reached.

### Actual Process Conditions

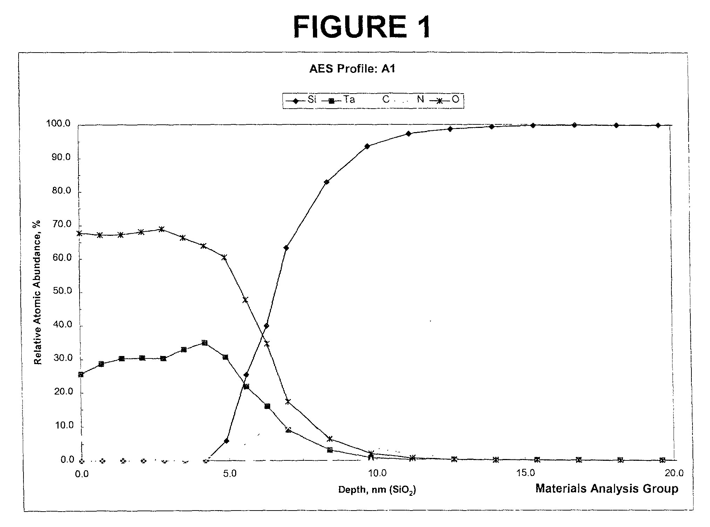

For this example, the tantalum is introduced at a flow rate of about 35 mg/minute for about 30 seconds, followed by a nitrogen purge at about 650 sccm for about 5 seconds. Subsequently, oxygen radicals are introduced at a flow rate of about 800 sccm for about 5 seconds. A nitrogen purge at about 650 sccm for about 5 seconds is then used again. The pressure used is about 4 Torr, while the temperature is selected to be constant within a range of about 250°C to about 350°C. This procedure is repeated until the desired film thickness (about 50-80 Angstroms) is reached. The reaction is complete and precisely stoichiometric, as seen in FIG. 1, which is an auger electron spectroscopy ("AES") depth profile for the Ta₂O₅ film. The AES data indicates an oxygen to tantalum ratio of 2.5:1, which is the desired stoichiometry.

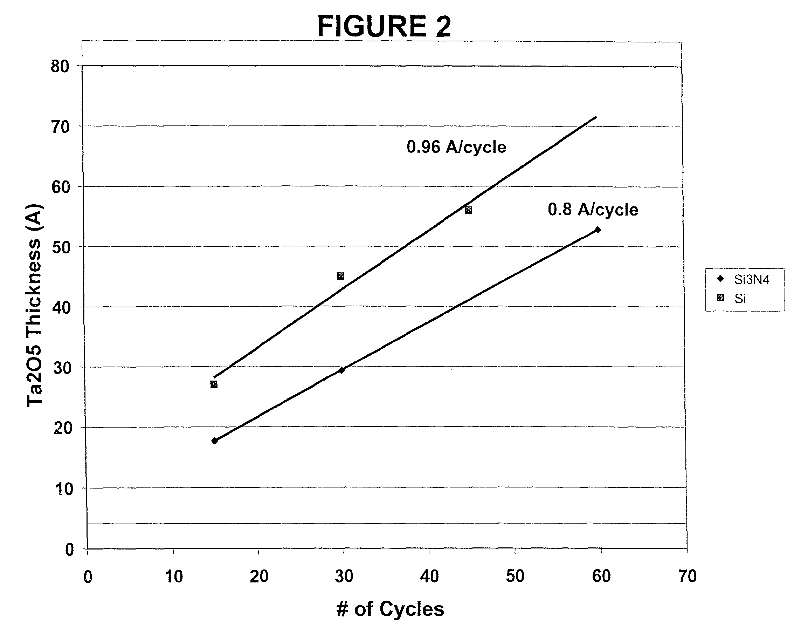

The process of the present invention has a film growth rate (or "deposition rate") of about 0.96 Angstroms per cycle. FIG. 2, which is a graph depicting the thickness of the film versus the number of cycles, shows that the chemistry of Ta(OC₂H₅)₅ and O₂ radicals as reactants in forming a Ta₂O₅ film exhibits a deposition rate of about 0.8 Angstroms per cycle to about 1.0 Angstroms per cycle depending on the substrate used. This deposition rate according to the present invention is faster than that of currently used chemistries.

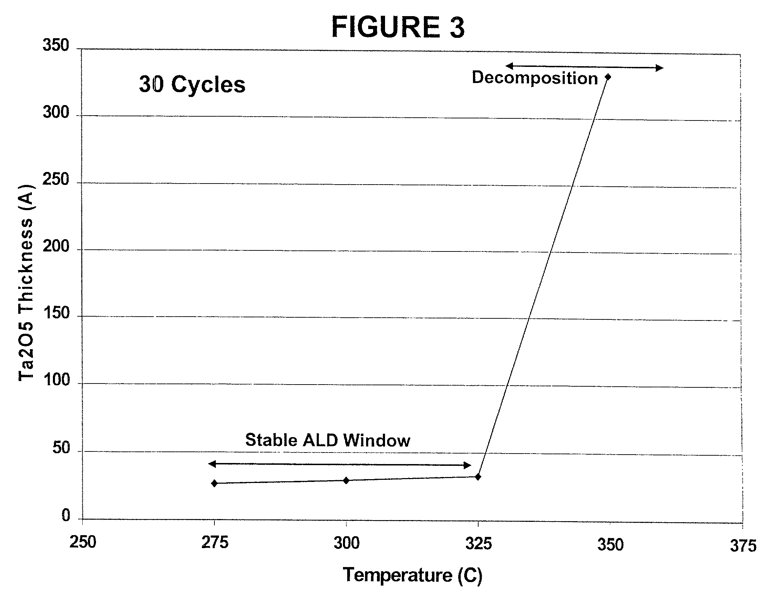

FIG. 3 is a graph depicting the ALD temperature window for Ta₂O₅ film using Ta(OC₂H₅)₅ and O₂ radicals as reactants. As seen therein, the ALD process of the present invention is stable within the desired temperature range as is consistent with ALD processes.

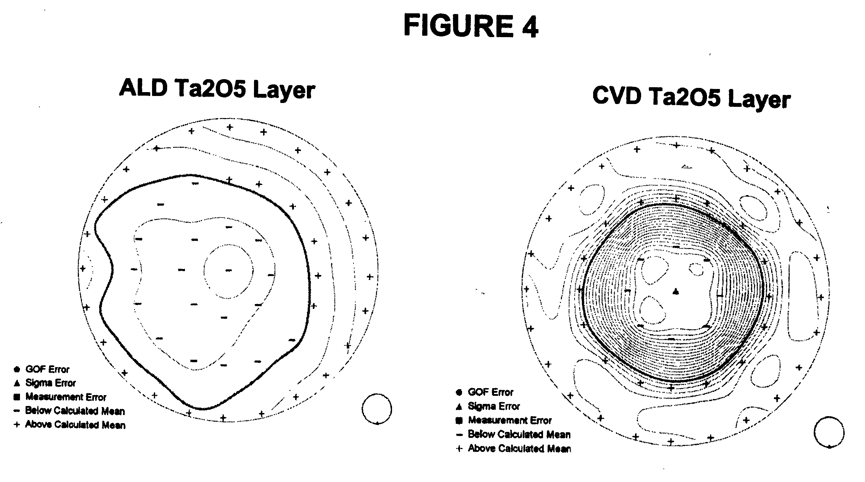

FIG. 4 illustrates uniformity maps for Ta₂O₅ films made using ALD according to the present invention and CVD. In FIG. 4, it is evident that the ALD process of the present invention exhibits better uniformity than CVD.

Having now fully described the invention, it will be apparent to one of ordinary skill in the art that changes and modifications can be made thereto without departing from the spirit or scope of the invention as set forth herein.

## Claims

1. A method of forming and growing a stoichiometric, high-k dielectric thin film on a surface of a substrate, the method comprising:
placing the substrate in a reaction chamber;
forming a single atomic layer of a first reactant on the substrate surface by subjecting the substrate surface to the first reactant, wherein the first reactant comprises tantalum and wherein the first reactant is in a vapor phase;
purging the chamber of unreacted first reactant; forming a single atomic layer of a second reactant on the substrate surface by subjecting the substrate surface to the second reactant, wherein the second reactant is in a vapor phase; and
purging the chamber of unreacted second reactant; alternately subjecting the substrate surface to the reactants in the vapor phase until the formed thin film reaches a desired thickness.

2. The method of Claim 1, wherein the first reactant is or comprises one or more of Ta(OC₂H₅)₅, [(CH₃CH₂)₂N]₃Ta, TaCl₅ and TaF₅.

3. The method of Claim 1 or Claim 2, wherein the second reactant is or comprises one or more of oxygen radicals, ozone and water vapor.

4. The method of any one of Claims 1 to 3, wherein the purge gas is or comprises one or more of argon, nitrogen and helium.

5. The method of any one of Claims 1 to 4, wherein the chamber has a pressure of from about 0.1 Torr to about 500 Torr.

6. The method of any one of Claims 1 to 5, wherein the thin film is or comprises one or both of Ta₂O₅ and TaₓO_{y}N_{z}.

7. The method of Claim 6, wherein the thin film is or comprises Ta₂O₅, and the first reactant is or comprises Ta(OC₂H₅)₅.

8. The method of Claim 6, wherein the thin film is or comprises Ta₂O₅, and the first reactant is or comprises [(CH₃CH₂)₂N]₃Ta.

9. The method of Claim 6, wherein the thin film is or comprises Ta₂O₅, and the first reactant is or comprises TaCl₅.

10. The method of Claim 6, wherein the thin film is or comprises Ta₂O₅, and the first reactant is or comprises TaF₅.

11. The method of Claim 6, wherein the thin film is or comprises TaₓO_{y}N_{z}, and the first reactant is or comprises [(CH₃CH₂)₂N]₃Ta.

12. The method of any one of Claims 1 to 11, further comprising, after the step of purging the chamber of unreacted second reactant:
forming a single atomic layer of a third reactant on the substrate surface by subjecting the substrate surface to the third reactant, wherein the third reactant is in a vapor phase;
purging the chamber of unreacted third reactant; forming a single atomic layer of a fourth reactant on the substrate surface by subjecting the substrate surface to the fourth reactant, wherein the fourth reactant is in a vapor phase; and
purging the chamber of unreacted fourth reactant.

13. The method of Claim 12, wherein the thin film is or comprises TaAlO₄.

14. The method of Claim 12 or Claim 13, wherein the first reactant is or comprises Ta(OC₂H₅)₅.

15. The method of Claim 12 or Claim 13, wherein the first reactant is or comprises [(CH₃CH₂)₂N]₃Ta.

16. The method of Claim 12 or Claim 13, wherein the first reactant is or comprises TaCl₅.

17. The method of Claim 12 or Claim 13, wherein the first reactant is or comprises TaF₅.

18. The method of any one of claims 6 to 17, wherein the second reactant is or comprises one or more of oxygen radicals, ozone and water vapor.

19. The method of any one of claims 12 to 18, wherein the the third reactant is or comprises one or more of trimethyl aluminum, dimethyl aluminum and isopropoxy aluminum.

20. The method of any one of claims 12 to 19, wherein the fourth reactant is or comprises one or more of oxygen radicals, ozone and water vapor.

21. The method of any one of claims 12 to 20, wherein the second reactant is the same as the fourth reactant.
